# DEMANDE DE BREVET EUROPEEN

(11) **EP 3 709 671 A1**
(43) Date de publication de la demande: **16.09.2020**
(21) Numéro de dépôt: 20162194.3
(22) Date de dépôt: 10.03.2020
(51) Int. Cl.: H04Q 9/00, G01D 4/00, H04B 3/54, H02J 13/00

(54) **COMPTEUR CENTRALISATEUR POUR GESTION AUTOMATISÉE DE COMPTAGE D'UN SERVICE DE DISTRIBUTION ÉLECTRIQUE**

(30) Priorité: 13.03.2019 FR 1902571; 13.03.2019 FR 1902572
(71) Demandeur: Sagemcom Energy & Telecom SAS, 92500 Rueil-Malmaison (FR)
(72) Inventeur: TEBOULLE, Henri, 92500 RUEIL MALMAISON (FR); GRINCOURT, Christophe, 92500 RUEIL MALMAISON (FR)
(74) Mandataire: Cabinet Le Guen Maillet

(57) **Abrégé**

Dans un système de gestion automatisée de comptage dans le cadre d'un service de distribution électrique, un compteur centralisateur (120) est connecté à un concentrateur de données (110) via un premier réseau de communication par courants porteurs en ligne (100) agissant dans une première bande fréquentielle. Le compteur centralisateur (120) est aussi connecté à des compteurs basiques déportés (131, 132, 133) via un second réseau de communication par courants porteurs en ligne (101) agissant dans une seconde bande fréquentielle. Le compteur centralisateur (120) émule une application de compteur électrique intelligent vis-à-vis du concentrateur de données (110) pour chaque compteur basique déporté (131, 132, 133), et répond ainsi à des sollicitations applicatives du concentrateur de données (110) vis-à-vis des compteurs basiques déportés (131, 132, 133) dans le cadre du service de distribution électrique, en commandant les compteurs basiques déportés (131, 132, 133) grâce à un jeu de commandes atomiques de métrologie et de gestion de coupe-circuit.

## Description

### DOMAINE TECHNIQUE

La présente invention concerne des réseaux de communication par courants porteurs en ligne (« PowerLine Communications » en anglais) pour des systèmes de gestion automatisée de comptage AMM (« Automated Metering Management » en anglais).

### ETAT DE LA TECHNIQUE ANTERIEURE

Les réseaux de communication par courants porteurs en ligne pour des systèmes de gestion automatisée de comptage AMM ont fait leur apparition ces dernières années, notamment dans le cadre de services de distribution électrique. On peut par exemple citer le standard G3-PLC spécifié dans la recommandation ITU-T G.9903. Dans de tels réseaux de communication par courants porteurs en ligne, des communications sont établies entre des compteurs électriques, dits *compteurs électriques intelligents* (« smart electricity meters » en anglais), et un nœud concentrateur, parfois appelé *concentrateur de données* (« data concentrator » en anglais) ou *nœud de base* (« base node » en anglais) ou *coordinateur* (« coordinator » en anglais), pour permettre notamment une relève automatisée à distance de mesures de consommation électrique effectuées par lesdits compteurs électriques intelligents et pour permettre d'une manière générale une prise de contrôle à distance des compteurs électriques. Plusieurs concentrateurs de données sont alors géographiquement déployés pour répartir la charge de collecte de relevés de comptage des compteurs électriques intelligents. Chaque concentrateur de données sert alors de relais entre les compteurs électriques intelligents et une entité de gestion du système de gestion automatisée de comptage AMM qui est en charge de traiter de manière centralisée les relevés de comptage.

Ainsi, les compteurs électriques intelligents deviennent plus autonomes et permettent d'éviter à un agent de l'opérateur de distribution d'électricité de se déplacer à domicile pour effectuer régulièrement les relevés de comptage. En contrepartie, l'architecture interne des compteurs électriques se complexifie, ce qui en accroît le coût de conception, de fabrication et de maintenance. En effet, de tels compteurs électriques intelligents comportent deux contrôleurs : un premier contrôleur dédié aux opérations de métrologie pour le comptage de consommation énergétique et un second contrôleur dédié aux opérations applicatives, à savoir la gestion d'interface utilisateur, la gestion calendaire et de courbes de charge, les opérations de qualimétrie et d'antifraude, et, surtout, la gestion des communications dans le système de gestion automatisée de comptage AMM. En effet, la gestion des communications dans le système de gestion automatisée de comptage AMM repose sur des encapsulations applicatives typiquement conformes au standard DLMS/COSEM (« Device Language Message Specification / Companion Specification for Energy Metering » en anglais), tel que décrit dans le document normatif IEC 62056-5-3 et dans la 12e édition du document « Bluebook : COSEM Interface Classes and OBIS Object Identification System » édité par le DLMS User Association, ce qui nécessite d'importantes ressources de traitement dans les compteurs électriques intelligents.

Il est alors souhaitable de pallier ces inconvénients de l'état de la technique. Il est notamment souhaitable de fournir une solution qui permette de limiter les ressources matérielles de compteurs électriques intelligents utilisés dans des systèmes de gestion automatisée de comptage AMM dans le cadre de services de distribution électrique.

### EXPOSE DE L'INVENTION

Un objet de la présente invention est de proposer un dispositif, appelé compteur centralisateur, destiné à être inclus dans un système de gestion automatisée de comptage dans le cadre d'un service de distribution électrique, le compteur centralisateur comportant une première unité de communication par courants porteurs en ligne configurée pour effectuer des communications par courants porteurs en ligne dans une première bande fréquentielle, la première unité de communication par courants porteurs en ligne étant destinée à communiquer avec un concentrateur de données via un premier réseau de communication par courants porteurs en ligne. Le compteur centralisateur comporte en outre : une seconde unité de communication par courants porteurs en ligne configurée pour effectuer des communications par courants porteurs en ligne dans une seconde bande fréquentielle distincte de la première bande fréquentielle, la seconde unité de communication par courants porteurs en ligne étant destinée à communiquer avec une pluralité de dispositifs, appelés compteurs basiques déportés, via un second réseau de communication par courants porteurs en ligne ; une unité de contrôle configurée pour émuler une application de compteur électrique intelligent vis-à-vis du concentrateur de données pour chaque compteur basique déporté enregistré auprès du compteur centralisateur via le second réseau de communication par courants porteurs en ligne, de sorte que chaque compteur basique déporté est perçu par le concentrateur de données comme étant localisé dans le compteur centralisateur au sein du premier réseau de communication par courants porteurs en ligne. De plus, l'unité de contrôle est configurée pour répondre à des sollicitations applicatives du concentrateur de données vis-à-vis des compteurs basiques déportés dans le cadre du service de distribution électrique, en commandant les compteurs basiques déportés grâce à un jeu de commandes atomiques de métrologie et de gestion de coupe-circuit. Ainsi, l'essentiel des traitements applicatifs qui requiert l'essentiel des ressources matérielles de traitement usuellement requises dans les compteurs électriques intelligents est mutualisé au sein du compteur centralisateur pour les compteurs basiques déportés qui lui sont rattachés, ce qui permet de préserver des ressources matérielles de compteurs électriques intelligents.

Selon un mode de réalisation particulier, la première unité de communication est munie d'un premier filtre adapté pour supprimer la seconde bande fréquentielle.

Selon un mode de réalisation particulier, la seconde unité de communication est munie d'un second filtre adapté pour supprimer la première bande fréquentielle.

Selon un mode de réalisation particulier, la première bande fréquentielle est de type CENELEC-A et la seconde bande fréquentielle est de type FCC.

Selon un mode de réalisation particulier, le compteur centralisateur comporte en outre une unité d'interface utilisateur, l'unité d'interface utilisateur comportant un afficheur et un panneau de contrôle adapté pour permettre à un utilisateur de saisir un mot de passe, et dans lequel l'unité de contrôle est configurée pour vérifier qu'un mot de passe saisi pour un compteur basique déporté correspond à un mot de passe attendu pour ledit compteur basique déporté, et si tel est le cas, l'unité de contrôle est configurée pour récupérer un relevé d'index de comptage auprès de l'instance de l'application émulée correspondant audit compteur basique déporté et pour instruire l'unité d'interface utilisateur d'afficher sur l'afficheur le relevé d'index de comptage récupéré.

L'invention concerne également un système de comptage destiné à être utilisé dans un système de gestion automatisée de comptage destiné à être utilisé dans le cadre d'un service de distribution électrique, le système de comptage comportant le compteur centralisateur et la pluralité de compteurs basiques déportés, connectés au compteur centralisateur via le second réseau de communication par courants porteurs en ligne.

Selon un mode de réalisation, le jeu de commandes atomiques de métrologie et de gestion de coupe-circuit inclut une commande de mise à l'heure, qui est utilisée pour horodater des relevés d'index de comptage effectués par l'unité de métrologie de chaque compteur basique déporté.

L'invention concerne également un système de gestion automatisée de comptage destiné à être utilisé dans le cadre d'un service de distribution électrique comportant : le système de comptage ; le premier réseau de communication par courants porteurs en ligne ; le concentrateur de données ; et des compteurs électriques intelligents connectés au concentrateur de données via le premier réseau de communication par courants porteurs en ligne.

Selon un mode de réalisation particulier, le second réseau de communication par courants porteurs en ligne a une topologie en étoile et le premier réseau de communication par courants porteurs en ligne a une topologie maillée ou en arbre de recouvrement.

L'invention concerne également un procédé implémenté par un dispositif, appelé compteur centralisateur, inclus dans un système de gestion automatisée de comptage dans le cadre d'un service de distribution électrique, le procédé comportant l'étape suivante : effectuer des communications par courants porteurs en ligne dans une première bande fréquentielle avec un concentrateur de données via un premier réseau de communication par courants porteurs en ligne. En outre, le procédé comporte les étapes suivantes : effectuer des communications par courants porteurs en ligne dans une seconde bande fréquentielle distincte de la première bande fréquentielle avec une pluralité de dispositifs, appelés compteurs basiques déportés, via un second réseau de communication par courants porteurs en ligne ; émuler une application de compteur électrique intelligent vis-à-vis du concentrateur de données pour chaque compteur basique déporté enregistré auprès du compteur centralisateur via le second réseau de communication par courants porteurs en ligne, de sorte que chaque compteur basique déporté est perçu par le concentrateur de données comme étant localisé dans le compteur centralisateur au sein du premier réseau de communication par courants porteurs en ligne ; et répondre à des sollicitations applicatives du concentrateur de données vis-à-vis des compteurs basiques déportés dans le cadre du service de distribution électrique, en commandant les compteurs basiques déportés grâce à un jeu de commandes atomiques de métrologie et de gestion de coupe-circuit.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également des moyens de stockage comprenant un tel programme d'ordinateur.

### BREVE DESCRIPTION DES DESSINS

Les caractéristiques de l'invention mentionnées ci-dessus, ainsi que d'autres, apparaîtront plus clairement à la lecture de la description suivante d'au moins un exemple de réalisation, ladite description étant faite en relation avec les dessins joints, parmi lesquels :
[Fig. 1] illustre schématiquement un système de communication, supportant une gestion automatisée de comptage, dans lequel la présente invention est implémentée ;
[Fig. 2] illustre schématiquement un exemple d'agencement matériel d'une unité de contrôle utilisée dans le système de communication ;
[Fig. 3A] illustre schématiquement un agencement de compteur centralisateur du système de communication ;
[Fig. 3B] illustre schématiquement un agencement de compteur basique déporté du système de communication ;
[Fig. 4] illustre schématiquement des échanges entre un compteur basique déporté et un compteur centralisateur dans le système de communication ; et
[Fig. 5] illustre schématiquement des échanges entre un compteur centralisateur et un concentrateur de données dans le système de communication.

### EXPOSE DETAILLE DE MODES DE REALISATION

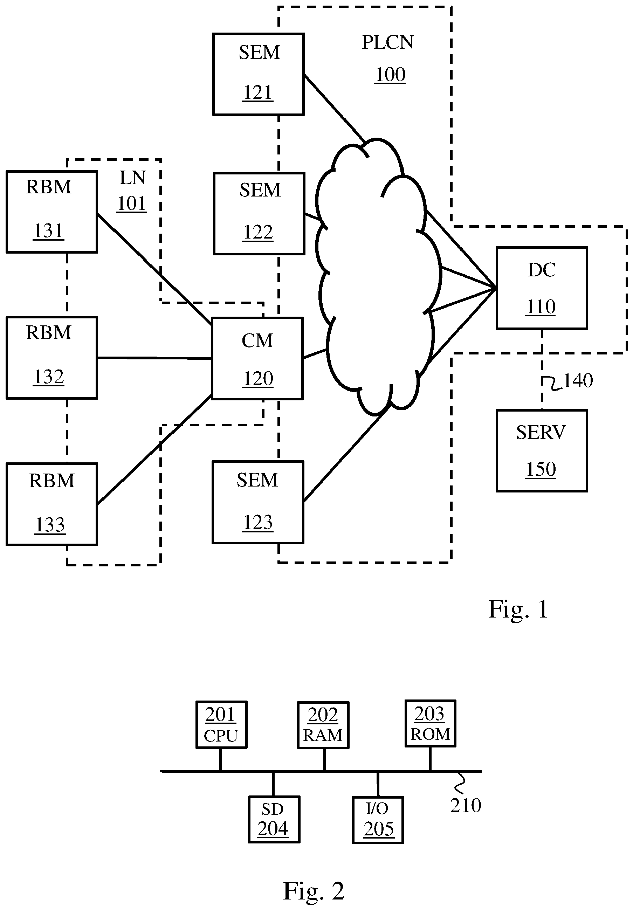

La **Fig. 1** illustre ainsi schématiquement un exemple d'un système de communication, supportant une gestion automatisée de comptage AMM dans le cadre de services de distribution électrique, dans lequel la présente invention est implémentée.

Le système de communication comporte au moins un réseau de communication par courants porteurs en ligne PLCN (« PowerLine Communications Network » en anglais) 100, simplement dénommé réseau PLCN 100 par la suite, déployé de manière logique sur un réseau d'alimentation électrique. Le réseau PLCN 100 permet la mise en place d'un système de gestion automatisée de comptage AMM dans le cadre des services de distribution électrique.

Le système de communication comporte un dispositif nœud particulier, appelé concentrateur de données DC (« data concentrator » en anglais). Le réseau PLCN 100 est destiné à permettre de connecter une pluralité de dispositifs nœuds au concentrateur de données DC 110. Les dispositifs nœuds que le réseau PLCN 100 vise à connecter au concentrateur de données DC 110 sont des compteurs électriques intelligents SEM (« smart electricity meters » en anglais) 121, 122, 123. Le réseau PLCN 100 permet ainsi d'établir des communications par courants porteurs en ligne (« powerline communications » en anglais), afin que le concentrateur de données DC 110 puisse notamment procéder automatiquement à des opérations de collecte de relevés de comptage de consommation électrique, ledit comptage étant effectué par les compteurs électriques intelligents vis-à-vis d'installations électriques que lesdits compteurs électriques intelligents sont respectivement en charge de superviser. Le réseau PLCN 100 permet notamment en outre au concentrateur de données DC 110 de procéder à des opérations de mise à jour applicative auprès des compteurs électriques intelligents, et d'une manière générale, de contrôler à distance lesdits compteurs électriques intelligents. Les communications par courants porteurs en ligne via le réseau PLCN 100 sont préférentiellement conformes au protocole G3-PLC. En variante, les communications par courants porteurs en ligne via le réseau PLCN 100 sont préférentiellement conformes aux spécifications PRIME (« "PoweRline Intelligent Metering Evolution » en anglais, telles que définies dans le document normatif ITU G.9904).

Le système de communication comporte en outre une entité de gestion du système de gestion automatisée de comptage AMM qui est notamment en charge de traiter de manière centralisée les relevés de comptage. L'entité de gestion du système de gestion automatisée de comptage AMM prend la forme d'un serveur SERV 150, ou d'un ensemble de serveurs, auquel le concentrateur de données DC 110 est connecté via un lien de communication 140. Le lien de communication 140 est un lien de communication sans-fil, par exemple de type GPRS (« General Packet Radio Service » en anglais), UMTS (« Universal Mobile Telecommunication System » en anglais) ou LTE (« Long-Term Evolution » en anglais). Le lien de communication 140 peut en variante être un lien de communication filaire.

Le concentrateur de données DC 110 effectue les opérations de collecte de relevés de comptage pour le compte du serveur SERV 150. En d'autres termes, le concentrateur de données DC 110 collecte les relevés de comptage auprès des compteurs électriques intelligents qui lui sont rattachés (*i.e.* les compteurs électriques intelligents du réseau PLCN 100), puis fournit lesdits relevés au serveur SERV 150 pour traitement. De plus, le concentrateur de données DC 110 assure préférentiellement les opérations de mise à jour applicative pour le compte du serveur SERV 150. Les opérations de mise à jour applicative sont réalisées par le concentrateur de données DC 110, bloc de données par bloc de données, auprès des compteurs électriques intelligents qui lui sont rattachés. Le concentrateur de données DC 110 gère les éventuels besoins de retransmission au sein du réseau PLCN 100 pour assurer un bon déroulement des opérations de collecte de relevés de comptage et des éventuelles opérations de mise à jour applicative. Dans un tel système de gestion automatisée de comptage AMM, le serveur SERV 150 s'appuie typiquement sur une pluralité de tels concentrateurs de données parmi lesquels l'exploitation à distance des compteurs électriques intelligents est répartie.

Le réseau PLCN 100 comporte au moins un compteur centralisateur CM (« Centralizing Meter » en anglais) 120. Le compteur centralisateur CM 120 sert de dispositif mandataire (« proxy » en anglais) pour une pluralité de compteurs basiques déportés RBM (« Remote Basic Meter » en anglais) 131, 132, 133. Du point de vue du réseau PLCN 100 et donc du concentrateur de données DC 110, les compteurs basiques déportés RBM 131, 132, 133 sont masqués par le compteur centralisateur CM 120, dans lequel sont centralisées les applications qui auraient été nécessaires aux compteurs basiques déportés RBM 131, 132, 133 pour communiquer avec le concentrateur de données DC 110 si lesdits compteurs basiques déportés RBM 131, 132, 133 avaient été directement connectés au réseau PLCN 100. Les compteurs basiques déportés RBM 131, 132, 133 sont ainsi bien moins complexes, et donc moins coûteux en termes de ressources matérielles et énergétiques, que les compteurs électriques intelligents SEM 121, 122, 123 qui sont adaptés pour communiquer avec le concentrateur de données DC 110 directement via le réseau PLCN 100.

Le compteur centralisateur CM 120 est ainsi destiné à équiper un complexe immobilier, tel qu'un immeuble ou un quartier résidentiel, dans lequel chaque local ou logement est équipé d'un compteur basique déporté RBM. Cela forme un système de comptage dédié au complexe immobilier.

Comme détaillé ci-après, le compteur centralisateur CM 120 instancie une application émulée pour chaque compteur basique déporté RBM qui lui est rattaché, chaque application émulée ainsi instanciée étant en communication avec le concentrateur de données DC 110 comme si les compteurs électriques intelligents ainsi émulés étaient localisés dans le compteur centralisateur CM 120. En d'autres termes, le compteur centralisateur CM 120 émule, vis-à-vis du concentrateur de données DC 110, un comportement de compteur électrique intelligent pour chaque compteur basique déporté RBM qui lui est rattaché, bien que le compteur centralisateur CM 120 ne procède pas lui-même au comptage de consommation électrique. Comme détaillé ci-après, chaque compteur basique déporté RBM effectue le comptage de consommation électrique pour le logement ou local concerné, et en informe le compteur centralisateur CM auquel ledit compteur basique déporté RBM est rattaché, grâce à un protocole simplifié par rapport au protocole de communication avec le concentrateur de données DC 110. En charge alors au compteur centralisateur CM en question de gérer la complexité et la variété des échanges avec le concentrateur de données DC 110, qui sont typiquement régis par le format DLMS/COSEM (« Device Language Message Specification / Companion Specification for Energy Metering » en anglais), tels que décrits dans le document normatif IEC 62056-5-3 et dans la 12e édition du document « Bluebook : COSEM Interface Classes and OBIS Object Identification System » édité par le DLMS User Association, sont ainsi préférentiellement utilisés pour effectuer les opérations de relevé de comptage et de mise à jour applicative. Un compteur électrique intelligent dispose typiquement de plus de 500 objets COSEM parmi lesquels les courbes de charges, les calendriers, les tarifs, les index, ainsi que toutes les interfaces (organes de coupure (« breaker » en anglais), modem, Flag optique...). Le protocole DLMS permet de faire des appels de type SET et GET, ainsi que d'autres actions spécifiques sur ces objets. On peut configurer des paramètres de compteurs électriques intelligents via des appels de type SET (paramètres modem, paramètres applicatifs tels que les tarifs...), relever des courbes de charge (typiquement les courbes permettant une relève toutes les 15 minutes) via des appels de type GET, et ouvrir ou fermer leurs organes de coupure via des actions spécifiques. L'application d'un compteur électrique intelligent génère et stocke les objets COSEM et les met à jour régulièrement, les lit afin de les remonter vers le concentrateur de données DC 110 ou agit sur eux le cas échéant en fonction des échanges protocolaires avec le concentrateur de données DC 110.

Les communications entre chaque compteur basique déporté RBM 131, 132, 133 et le compteur centralisateur CM 120 sont aussi des communications par courants porteurs en ligne. Cela forme un autre réseau de communication par courants porteurs en ligne LN 101 distinct du réseau PLCN 100. Les compteurs basiques déportés RBM 131, 132, 133 sont connectés, de manière logique, directement au compteur centralisateur CM 120. Le réseau LN 101 a ainsi une topologie en étoile (« star topology » en anglais), alors que le réseau PLCN 100 a une topologie maillée (« mesh topology » en anglais), comme dans le cadre du protocole G3-PLC, ou une topologie en arbre de recouvrement (« spanning tree topology » en anglais), comme dans le cadre des spécifications PRIME.

De sorte à assurer que les compteurs basiques déportés RBM 131, 132, 133 soient masqués du concentrateur de données DC 110, des bandes fréquentielles distinctes sont utilisées. Les communications par courants porteurs en ligne sur le réseau PLCN 100 utilisent donc une première bande fréquentielle et les communications entre les compteurs basiques déportés RBM 131, 132, 133 et le compteur centralisateur CM 120 utilisent une seconde bande fréquentielle distincte de la première bande fréquentielle (i.e., qui ne se chevauche pas avec la première bande fréquentielle). Par exemple, le protocole G3-PLC et les spécifications PRIME définissent différentes bandes fréquentielles distinctes utilisables, notamment : une première bande fréquentielle CENELEC-A, qui va d'approximativement 35 kHz à 91 kHz ; une seconde bande fréquentielle FCC, qui va approximativement de 150 kHz à 480 kHz ; une troisième bande fréquentielle CENELEC-B, qui va approximativement de 98 kHz à 122 kHz. Dans un mode de réalisation préférentiel, le compteur centralisateur CM 120 utilise la bande fréquentielle CENELEC-A pour communiquer avec le concentrateur de données DC 110 et la bande fréquentielle FCC pour communiquer avec chaque compteur basique déporté RBM 131, 132, 133 géré par ledit compteur centralisateur CM 120.

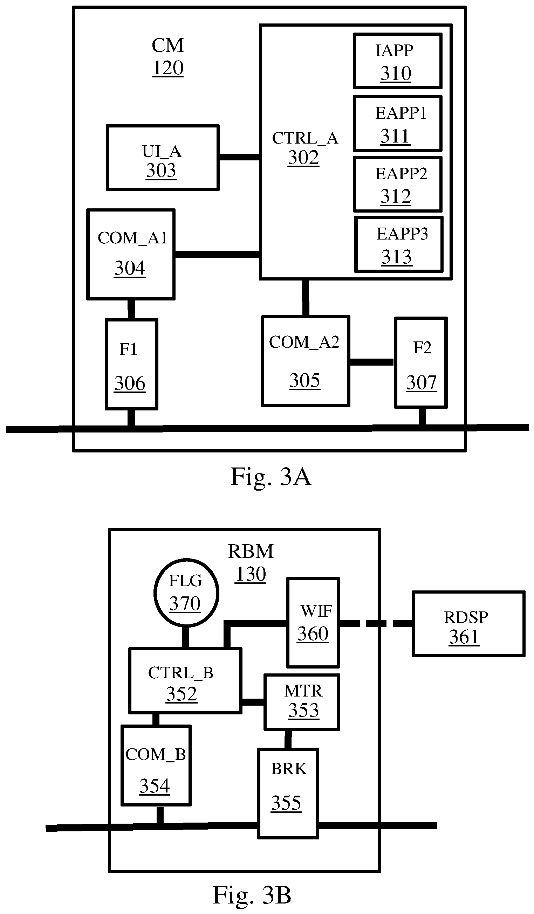

La **Fig. 2** illustre schématiquement un exemple d'agencement matériel d'une unité de contrôle utilisée dans le système de communication du système de communication de la Fig. 1. Une telle unité de contrôle se retrouve dans chaque compteur basique déporté RBM 131, 132, 133 et dans le compteur centralisateur CM 120, tel que détaillé ci-après en relation avec les Figs. 3A et 3B.

L'exemple d'architecture matérielle présenté comporte, reliés par un bus de communication 210 : un processeur CPU 201 ; une mémoire vive RAM (« Random Access Memory » en anglais) 202 ; une mémoire morte ROM (« Read Only Memory » en anglais) 203 ou une mémoire Flash ; une unité de stockage ou un lecteur de support de stockage, tel qu'un lecteur de cartes SD (« Secure Digital » en anglais) 204 ; et un ensemble d'interfaces d'entrée/sortie I/O 205. L'ensemble d'interfaces de communication COM 305 permet à l'unité de contrôle d'interagir avec d'autres composantes au sein d'un même dispositif, tel que détaillé ci-après en relation avec les Figs. 3A et 3B.

Le processeur CPU 201 est capable d'exécuter des instructions chargées dans la mémoire RAM 202 à partir de la mémoire ROM 203, d'une mémoire externe (telle qu'une carte SD), d'un support de stockage ou d'un réseau de communication. Lors de la mise sous tension, le processeur CPU 201 est capable de lire de la mémoire RAM 202 des instructions et de les exécuter. Ces instructions forment un programme d'ordinateur causant la mise en œuvre, par le processeur CPU 201, de tout ou partie des procédés et étapes décrits ici.

Ainsi, tout ou partie des procédés et étapes décrits ici peut être implémenté sous forme logicielle par exécution d'un ensemble d'instructions par une machine programmable, telle qu'un DSP (« Digital Signal Processor » en anglais) ou un microcontrôleur ou un processeur. Tout ou partie des procédés et étapes décrits ici peut aussi être implémenté sous forme matérielle par une machine ou un composant dédié, tel qu'un FPGA (« Field-Programmable Gate Array » en anglais) ou un ASIC (« Application-Specific Integrated Circuit » en anglais). Ainsi, l'unité de contrôle comporte de la circuiterie électronique adaptée et configurée pour implémenter les procédés et étapes décrits ici.

La **Fig. 3A** illustre schématiquement un agencement du compteur centralisateur CM 120, dans un mode de réalisation particulier.

Le compteur centralisateur CM 120 comporte une unité de contrôle CTRL_A 302. L'unité de contrôle CTRL_A 302 est en charge de superviser le fonctionnement du compteur centralisateur CM 120.

Le compteur centralisateur CM 120 comporte en outre une première unité de communication COM_A1 304 destinée à permettre de communiquer par courants porteurs en ligne avec le concentrateur de données DC 110 (i.e., via le réseau PLCN 100). La première unité de communication COM_A1 304 agit donc dans la première bande fréquentielle.

Le compteur centralisateur CM 120 comporte en outre une seconde unité de communication COM_A2 305 destinée à permettre de communiquer par courants porteurs en ligne avec chaque compteur basique déporté RBM rattaché au compteur centralisateur CM 120. La seconde unité de communication COM_A2 305 agit donc dans la seconde bande fréquentielle.

Dans un mode de réalisation particulier, la première unité de communication COM_A1 304 est munie d'un premier filtre F1 306 adapté et configuré pour supprimer les signaux de la bande fréquentielle des communications par courants porteurs en ligne avec la seconde unité de communication COM_A2 305. Ainsi, les communications avec le réseau PLCN 100 subissent moins d'interférences de la part des communications avec les compteurs basiques déportés RBM 131, 132, 133 rattachés au compteur centralisateur CM 120.

Dans un mode de réalisation particulier, la seconde unité de communication COM_A2 305 est munie d'un second filtre F2 307 adapté et configuré pour supprimer les signaux de la bande fréquentielle des communications par courants porteurs en ligne avec la première unité de communication COM_A1 307. Ainsi, les communications avec les compteurs basiques déportés RBM 131, 132, 133 rattachés au compteur centralisateur CM 120 subissent moins d'interférences de la part des communications au sein du réseau PLCN 100.

A noter que dans le cas d'une distribution d'alimentation électrique en triphasé, il est possible d'injecter les signaux de communication en triphasé du côté de la seconde unité de communication COM_A2 et en monophasé ou en triphasé du côté de la première unité de communication COM_A1.

L'unité de contrôle CTRL_A 302 implémente une application interne IAPP 310. L'application interne IAPP 310 est notamment en charge d'instancier une application émulée EAPP pour chaque compteur basique déporté RBM rattaché au compteur centralisateur CM 120. Ainsi, l'unité de contrôle CTRL_A 302 comporte donc une instance d'application émulée EAPP pour chaque compteur basique déporté RBM rattaché au compteur centralisateur CM 120. De manière illustrative, comme trois compteurs basiques déportés RBM 131, 132, 133 sont rattachés au compteur centralisateur CM 120 sur la Fig. 1, la Fig. 3A montre trois applications émulées respectives EAPP 311, 312, 313.

Le compteur centralisateur CM 120 peut comporter en outre une unité d'interface utilisateur UI_A 303 adaptée pour interagir avec des utilisateurs. Dans un mode de réalisation particulier, l'unité d'interface utilisateur UI_A 303 comporte un afficheur permettant notamment d'afficher des relevés d'index de comptage correspondant aux compteurs basiques déportés RBM 131, 132, 133 rattachés au compteur centralisateur CM 120. L'unité d'interface utilisateur UI_A 303 comporte un panneau de contrôle adapté pour permettre aux utilisateurs de saisir un mot de passe. Chaque compteur basique déporté RBM 131, 132, 133 rattaché au compteur centralisateur CM 120 dispose de son propre mot de passe. L'unité de contrôle CTRL_A 302 est en charge de vérifier que le mot de passe saisi pour un compteur basique déporté RBM 131, 132, 133 correspond à un mot de passe attendu pour ledit compteur basique déporté RBM 131, 132, 133, et si tel est le cas, l'unité de contrôle CTRL_A 302 récupère le relevé d'index de comptage auprès de l'instance de l'application émulée EAPP correspondant audit compteur basique déporté RBM 131, 132, 133 et instruit l'unité d'interface utilisateur UI_A 303 d'afficher sur l'afficheur le relevé d'index de comptage récupéré. Un mot de passe par défaut est défini de manière déterministe pour chaque compteur basique déporté RBM 131, 132, 133. Le mot de passe de chaque compteur basique déporté RBM 131, 132, 133 peut être changé auprès du compteur centralisateur CM 120 grâce à l'unité d'interface utilisateur UI_A 303, le mot de passe ainsi changé étant alors mémorisé par le compteur centralisateur CM 120 en association avec l'instance de l'application émulée EAPP correspondante.

Contrairement aux compteurs basiques déportés RBM, le compteur centralisateur CM 120 ne comporte préférentiellement pas d'organe de coupure. En effet, le rôle du compteur centralisateur CM 120 n'est pas d'effectuer des opérations de métrologie et de protection des installations électriques, mais de centraliser l'intelligence applicative, et donc les ressources matérielles afférentes, pour le compte des compteurs basiques déportés RBM.

La **Fig. 3B** illustre schématiquement un agencement de compteur basique déporté RBM 130. Les compteurs basiques déportés RBM 131, 132, 133 sont agencés conformément à ce compteur basique déporté RBM 130, dans un mode de réalisation particulier.

Le compteur basique déporté RBM 130 comporte une unité de contrôle CTRL_B 352. L'unité de contrôle CTRL_B 352 est en charge de superviser le fonctionnement du compteur basique déporté RBM 130.

Le compteur basique déporté RBM 130 comporte en outre une unité de métrologie MTR 353 en charge de relever la consommation électrique de l'installation électrique que le compteur basique déporté RBM 130 est en charge de superviser. L'unité de contrôle CTRL_B 352 obtient ainsi auprès de l'unité de métrologie MTR 353, entre autres, des relevés d'index de comptage.

Le compteur basique déporté RBM 130 comporte en outre un organe de coupure BRK 355. L'organe de coupure BRK 355 est un coupe-circuit contrôlable à distance par l'opérateur et qui permet d'activer et de désactiver à volonté l'alimentation électrique de l'installation électrique supervisée par le compteur basique déporté RBM 130.

Le compteur basique déporté RBM 130 comporte en outre une unité de communication COM_B 354 destinée à permettre de communiquer par courants porteurs en ligne avec le compteur centralisateur CM auquel ledit compteur basique déporté RBM 130 est rattaché. L'unité de communication COM_B 354 agit dans la seconde bande fréquentielle.

Le compteur basique déporté RBM 130 comporte préférentiellement en outre une interface de communication optique FLG 370 permettant à un opérateur humain de venir brancher une sonde conforme au standard IEC 62056-21, aussi connue sous le nom de sonde « Flag ». Une telle sonde est reliée à un terminal mis à la disposition de l'opérateur humain, et permet d'effectuer un relevé d'index de comptage auprès du compteur basique déporté RBM 130 et éventuellement de modifier la configuration du compteur basique déporté RBM 130. Le compteur basique déporté RBM 130 comporte alors une rondelle métallique entourant un premier émetteur-récepteur optique (« optical transceiver » en anglais), et la sonde comporte une rondelle aimantée entourant un second émetteur-récepteur optique. L'agencement est tel que, lorsque l'opérateur humain utilise la sonde, la rondelle aimantée se place contre la rondelle métallique, de sorte que les premier et second émetteurs-récepteurs optiques sont en regard l'un de l'autre. Cet agencement permet de faciliter la mise en place de la sonde sur le compteur basique déporté RBM 130. Le compteur basique déporté RBM 130 peut comporter dans l'unité de contrôle CTRL_B 352 une zone mémoire adaptée pour stocker des relevés d'index de comptage fournis par intervalles réguliers de durée prédéfinie (e.g., toutes les 5 minutes) par l'unité de métrologie MTR 353 sur une plage temporelle prédéfinie (e.g., pendant les 2 derniers jours). L'opérateur humain peut alors récupérer, grâce à l'interface de communication optique FLG 370, les relevés d'index de comptage ainsi stockés.

Contrairement au compteur centralisateur CM 120, le compteur basique déporté RBM 130 ne comporte pas d'interface utilisateur (éventuellement quelques diodes électroluminescentes d'état de fonctionnement) et notamment pas d'afficheur. Cependant, le compteur basique déporté RBM 130 comporte préférentiellement en outre une interface de communication sans-fil WIF 360 adaptée et configurée pour transmettre des informations à afficher sur un afficheur distant (« remote display » en anglais) RDSP 361. Un tel afficheur distant RDSP 361 est typiquement installé dans le logement ou local dont l'installation électrique est supervisée par le compteur basique déporté RBM 130 en question. L'interface de communication sans-fil WIF 360 est par exemple de type WiFi, Zigbee, ou KNX-RF (i.e., KNX sur couche physique radiofréquence) tel que défini dans le standard ISO/IEC 14543. Les informations à afficher sur l'afficheur distant sont indiquées au compteur basique déporté RBM 130 par le compteur centralisateur CM 120 grâce à une commande spécifique, comme décrit ci-après.

A noter que dans un mode de réalisation particulier, un filtre du même type que le filtre F2 307 peut être intercalé entre l'unité de communication COM_B 354 et la ligne d'alimentation électrique.

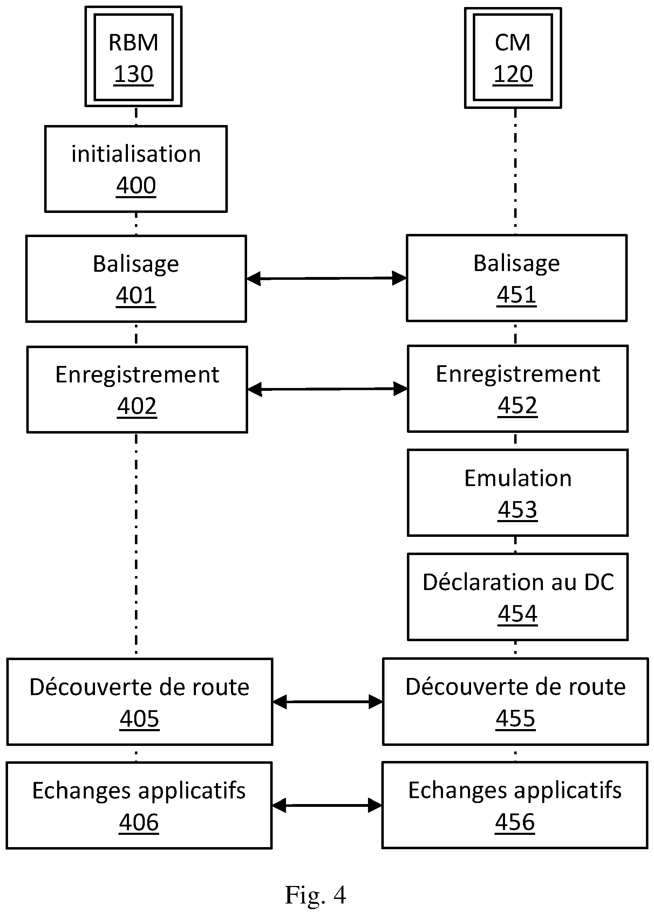

La **Fig. 4** illustre schématiquement des échanges entre un dit compteur basique déporté RBM 130 et le compteur centralisateur CM 120 auquel ledit compteur basique déporté RBM 130 doit être rattaché.

Dans une étape 400, le compteur basique déporté RBM 130 s'initialise, par exemple suite à une installation par un installateur agréé.

Dans une étape 401, le compteur basique déporté RBM 130 effectue une opération de balisage en coopération avec le compteur centralisateur CM 120 (étape 451). L'opération de balisage consiste pour le compteur basique déporté RBM 130 à détecter la présence du compteur centralisateur CM auquel se rattacher.

Dans un exemple de réalisation calqué sur le comportement du protocole 6LoWPAN (« IPv6 Low power Wireless Personal Area Networks » en anglais, tel que spécifié dans les documents normatifs RFC 4919 et 4944) utilisé dans le cadre du protocole G3-PLC, l'opération de balisage comporte la diffusion (« broadcast » en anglais) d'une requête de balisage (« beacon request » en anglais) par le compteur basique déporté RBM 130. Chaque dispositif connecté au réseau de distribution électrique captant la requête de balisage diffusée est supposé y répondre en mode point-à-point (« unicast » en anglais). Le compteur centralisateur CM 120 y répond. En effet, le réseau de distribution électrique est tel que la distance de câble électrique entre le compteur basique déporté RBM 130 et le compteur centralisateur CM 120 auquel ledit compteur basique déporté RBM 130 est supposé se rattacher est inférieure à la portée des communications par courants porteurs en ligne spécifiées pour les compteurs basiques déportés RBM.

D'autres compteurs basiques déportés RBM peuvent capter la requête de balisage diffusée. Dans un mode de réalisation, les compteurs basiques déportés RBM sont configurés pour répondre aux requêtes de balisage. Dans leur réponse, les compteurs basiques déportés RBM fournissent une information représentative du nombre de sauts qui les séparent du coordinateur de leur réseau, à savoir le compteur centralisateur CM auquel ils sont rattachés. Cela peut donc se faire de manière indirecte grâce à des informations de coût de route, dans la mesure où le routage est configuré de manière à ce qu'à un coût de route donné corresponde un et un seul nombre de sauts. Par exemple : un coût de route < 7 correspond à 0 saut, de 7 à 13 correspond à 1 saut, de 14 à 26 à 2 sauts, etc. Les compteurs basiques déportés RBM susceptibles de répondre ont déjà été enregistrés, et le nombre de sauts qui les séparent de leur compteur centralisateur CM est ainsi égal à « 1 » (connexion logique directe). Les compteurs basiques déportés RBM sont alors configurés pour écarter toute réponse qui indique un nombre non nul de sauts pour atteindre le coordinateur de réseau, à savoir le compteur centralisateur CM auquel ils sont supposés se rattacher. Dans un mode de réalisation, préférentiel, les compteurs basiques déportés RBM sont configurés pour ne pas répondre aux requêtes de balisage, et donc seul le compteur centralisateur CM 120 répond aux requêtes de balisage émis par les compteurs basiques déportés RBM qui sont susceptibles de lui être rattachés.

Dans une étape 402, le compteur basique déporté RBM 130 effectue une opération d'enregistrement en coopération avec le compteur centralisateur CM 120 (étape 452). L'opération d'enregistrement consiste à confirmer auprès du compteur centralisateur CM 120 que ledit compteur basique déporté RBM 130 a identifié le compteur centralisateur CM 120 comme étant son point de rattachement et à confirmer que le compteur centralisateur CM 120 a pris en compte l'apparition dudit compteur basique déporté RBM 130. Pendant l'opération d'enregistrement, le compteur centralisateur CM 120 et ledit compteur basique déporté RBM 130 s'authentifient mutuellement. Préférentiellement, pendant l'opération d'enregistrement, le compteur centralisateur CM 120 transmet audit compteur basique déporté RBM 130 des informations de sécurisation de communication destinées à sécuriser les échanges ultérieurs entre le compteur centralisateur CM 120 et ledit compteur basique déporté RBM 130.

Dans un exemple de réalisation calqué sur le comportement du protocole EAP-PSK (« Extensible Authentication Protocol with Pre-Shared Key » en anglais, tel que défini dans le document normatif RFC 4764) utilisé dans le cadre du protocole G3-PLC, le compteur basique déporté RBM 130 transmet au compteur centralisateur CM 120 une requête d'adhésion (« join request » en anglais), ce qui entraîne une première requête d'identification (« challenge request » en anglais) de la part du compteur centralisateur CM 120 à destination dudit compteur basique déporté RBM 130. Cette première requête d'identification inclut un premier nombre aléatoire, ainsi qu'un identifiant qui identifie le compteur centralisateur CM 120. Ledit compteur basique déporté RBM 130 transmet en retour une première réponse d'identification (« challenge response » en anglais) qui inclut un second nombre aléatoire, ainsi qu'un identifiant dudit compteur basique déporté RBM 130 et un premier résultat de calcul. Le premier résultat de calcul résulte d'une exécution de fonction prédéfinie prenant en entrée le premier nombre aléatoire, le second nombre aléatoire et une clef secrète PSK (« Pre-Shared Key » en anglais) connue dudit compteur basique déporté RBM 130 et du compteur centralisateur CM 120. La vérification du premier résultat de calcul par le compteur centralisateur CM 120 permet d'authentifier ledit compteur basique déporté RBM 130. Ensuite, le compteur centralisateur CM 120 transmet audit compteur basique déporté RBM 130 une seconde requête d'identification, qui inclut un second résultat de calcul. Le second résultat de calcul résulte d'une exécution de fonction prédéfinie prenant en entrée le second nombre aléatoire et la clef secrète PSK. La vérification du second résultat de calcul par ledit compteur basique déporté RBM 130 permet d'authentifier le compteur centralisateur CM 120. La seconde requête d'identification contient préférentiellement, sous forme chiffrée, une clef de chiffrement GMK_CC qui est utilisée par la suite pour chiffrer les échanges entre ledit compteur basique déporté RBM 130 et le compteur centralisateur CM 120.

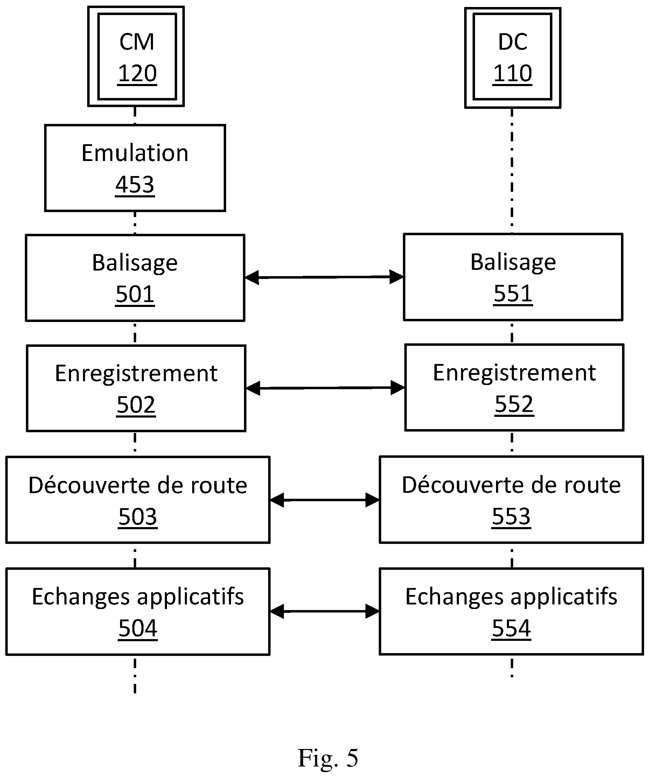

En conséquence de l'enregistrement par le compteur centralisateur CM 120 dudit compteur basique déporté RBM 130 dans l'étape 452, le compteur centralisateur CM 120 instancie une application émulée EAPP pour ledit compteur basique déporté RBM 130 dans une étape 453. Puis, dans une étape 454 le compteur centralisateur CM 120 déclare, grâce à ladite application émulée EAPP, ledit compteur basique déporté RBM 130 auprès du concentrateur de données DC 110. Un mode de réalisation est détaillé ci-après en relation avec la Fig. 5. Le concentrateur de données DC 110 voit ainsi ledit compteur basique déporté RBM 130 comme si ledit compteur basique déporté RBM 130 était un compteur électrique intelligent, avec des fonctionnalités complètes, directement implémenté par le compteur centralisateur CM 120.

Dans une étape 455 (qui peut se dérouler en parallèle de l'étape 453 et/ou de l'étape 454), le compteur centralisateur CM 120 effectue une opération de découverte de route en collaboration avec ledit compteur basique déporté RBM 130 (étape 405). L'opération de découverte de route consiste à mettre à jour des tables de routage respectives du compteur centralisateur CM 120 et dudit compteur basique déporté RBM 130 pour finaliser leur mise en communication.

Dans un exemple de réalisation calqué sur le comportement du protocole LOADng (« Lightweight On-demand Ad-hoc Distance-vector routing protocol - next generation » en anglais) utilisé dans le cadre du protocole G3-PLC, le compteur centralisateur CM 120 diffuse une requête de route (« route request » en anglais). La requête de route cible ledit compteur basique déporté RBM 130 et demande de découvrir quel chemin utiliser pour communiquer avec ledit compteur basique déporté RBM 130. Ledit compteur basique déporté RBM 130 transmet en retour, en mode point-à-point, une réponse de route (« route reply » en anglais). Le compteur centralisateur CM 120 et ledit compteur basique déporté RBM 130 mettent alors à jour leurs tables de routage respectives en indiquant que ledit compteur centralisateur CM 120 et ledit compteur basique déporté RBM 130 sont en connexion directe (i.e., un seul saut). Cette approche simplifie le déploiement des compteurs basiques déportés RBM 130 en réutilisant les mécanismes de routage communément utilisés dans le cadre des systèmes de gestion automatisée de comptage AMM.

Ensuite, dans une étape 456, le compteur centralisateur CM 120 est apte à mettre en place des échanges applicatifs, préférentiellement sécurisés, avec ledit compteur basique déporté RBM 130 (étape 406). Comme déjà évoqué, ces échanges applicatifs sont préférentiellement chiffrés grâce à la clef de chiffrement GMK_CC.

Grâce à ces échanges applicatifs, le compteur centralisateur CM 120 est apte à transmettre des trames de commandes atomiques audit compteur basique déporté RBM 130 et à recevoir en retour des trames de réponse de la part dudit compteur basique déporté RBM 130.

Cela permet que le compteur centralisateur CM 120 et les compteurs basiques déportés RBM qui lui sont rattachés n'aient à interagir que pour traiter des commandes atomiques de métrologie et de gestion de coupe-circuit, alors que les sollicitations applicatives en provenance du concentrateur de données DC 110 requièrent des traitements substantiellement plus complexes, tels que des traitements analytiques, des mises en forme et des encapsulations. Les commandes atomiques relèvent de mises à l'heure dudit compteur basique déporté RBM 130, d'ordres d'ouverture de l'organe de coupure BRK 355, d'ordres de fermeture de l'organe de coupure BRK 355, d'ordres d'envoi d'un relevé d'index de comptage, et de demandes de rapports sur l'état dudit compteur basique déporté RBM 130.

Lorsque ledit compteur basique déporté RBM 130 comporte l'interface de communication sans-fil WIF 360 afin de permettre l'utilisation de l'afficheur distant RDSP 361, le compteur centralisateur CM 120 est apte à ordonner un affichage sur ledit afficheur distant RDSP 361 d'une chaîne de caractères fournie en argument.

Chaque trame de commande atomique comporte par exemple un octet de commande, suivi éventuellement de données utiles (« payload data » en anglais) de taille prédéterminée en fonction de la commande en question. Par exemple, l'octet de commande prend les valeurs suivantes, les autres valeurs étant réservées pour de futurs usages :
0x01 : Commande de mise à l'heure, suivie de 6 octets de données utiles pour indiquer l'année, le mois, le jour, l'heure, la minute et la seconde courants ;
0x02 : Commande d'ouverture de l'organe de coupure BRK 355 ;
0x03 : Commande de fermeture de l'organe de coupure BRK 355 ;
0x04 : Commande d'envoi de relevé d'index de comptage ;
0x05 : Commande d'envoi d'état dudit compteur basique déporté RBM 130 ; et
0x06 : Commande d'affichage sur afficheur distant, suivie de 1 octet indiquant la taille M d'une chaîne de caractères à afficher, ainsi que de M octets contenant la chaîne de caractères à afficher.

Sur réception d'une telle trame de commande atomique, le compteur basique déporté RBM 130 effectue la commande en question ; la trame de réponse indique si la prise en compte de la commande a été un succès ou un échec. Chaque trame de réponse comporte par exemple un octet de réponse, suivi éventuellement de données utiles de taille prédéfinie en fonction de la commande ayant entraîné la réponse en question. Par exemple, l'octet de réponse prend les valeurs suivantes, les autres valeurs étant réservées pour de futurs usages :
0x01 : Acquittement simple ;
0x02 : Fourniture de relevé d'index de comptage, suivie de 4 octets d'index de comptage et de 6 octets d'horodatage correspondant ; et
0x03 : Fourniture d'état, suivie de 1 octet de statut.

Par exemple, l'octet de statut prend les valeurs suivantes :
0x00 : OK
0x01 : Fraude magnétique suspectée ;
0x02 : Fraude par contournement (« bypass » en anglais) suspectée ;
0x03 : Anomalie métrologique détectée ;
0x04 : Echauffement anormal détecté ; et
0x05 : Autre panne détectée.

Un bit peut être réservé dans l'octet de statut pour indiquer l'état du coupe-circuit opérateur UBRK 355 :
1 bit : Organe de coupure BRK 355 ouvert (« 0 ») / fermé (« 1 »).

La Fig. 5 illustre schématiquement des échanges entre le compteur centralisateur CM 120 et le concentrateur de données DC 110 via le réseau PLCN 100.

Suite à l'instanciation par le compteur centralisateur CM 120 d'une application émulée EAPP pour un dit compteur basique déporté RBM 130 dans l'étape 453, le compteur centralisateur CM 120 déclare, grâce à ladite application émulée EAPP, ledit compteur basique déporté RBM 130 auprès du concentrateur de données DC 110. Ainsi, dans une étape 501, le compteur centralisateur CM 120 effectue une opération de balisage en coopération avec le concentrateur de données DC 110 (étape 551). L'opération de balisage consiste à identifier pour l'application émulée EAPP en question comment se rattacher au réseau PLCN 100 pour être déclarée auprès du concentrateur de données DC 110. Comme pour l'algorithme de la Fig. 4, le protocole 6LoWPAN peut être utilisé ici. Une différence réside toutefois en ce que, dans le réseau PLCN 100, un ou plusieurs compteurs électriques intelligents SEM peuvent servir de relais pour atteindre le concentrateur de données DC 110.

Dans une étape 502, ladite application émulée EAPP effectue une opération d'enregistrement en coopération avec le concentrateur de données DC 110 (étape 552). L'opération d'enregistrement consiste à confirmer auprès du concentrateur de données DC 110 que ladite application émulée EAPP a identifié un point de rattachement au réseau PLCN 100 et à confirmer que le concentrateur de données DC 110 a pris en compte l'apparition du compteur électrique intelligent émulé par ladite application émulée EAPP. Pendant l'opération d'enregistrement, le concentrateur de données DC 110 et ladite application émulée EAPP s'authentifient mutuellement. Comme pour l'algorithme de la Fig. 4, le protocole EAP-PSK peut être utilisé ici.

Dans une étape 553, le concentrateur de données DC 110 effectue une opération de découverte de route en collaboration avec ladite application émulée EAPP (étape 503). L'opération de découverte de route consiste à mettre à jour des tables de routage respectives du concentrateur de données DC 110 et de ladite application émulée EAPP pour finaliser leur mise en communication. Comme pour l'algorithme de la Fig. 4, le protocole LOADng peut être utilisé ici. A noter que, dans ce cas, chaque application émulée EAPP instanciée au sein du compteur centralisateur CM 120 dispose de sa propre table de routage vis-à-vis du réseau PLCN 100.

Ensuite, dans une étape 504, le concentrateur de données DC 110 est apte à mettre en place des échanges applicatifs, préférentiellement sécurisés, avec ladite application émulée (étape 554).

Ainsi, grâce à son unité de contrôle CTRL_A 302 et aux applications émulées EAPP, le compteur centralisateur CM 120 est apte à répondre à des sollicitations applicatives du concentrateur de données DC 110 vis-à-vis des compteurs basiques déportés RBM 131, 132, 133 dans le cadre du service de distribution électrique, en commandant les compteurs basiques déportés RBM 131, 132, 133 grâce à un jeu de commandes atomiques de métrologie et de gestion de coupe-circuit. L'essentiel des traitements applicatifs qui requiert l'essentiel des ressources matérielles de traitement usuellement requises dans les compteurs électriques intelligents est ainsi mutualisé au sein du compteur centralisateur CM 120 pour les compteurs basiques déportés RBM 131, 132, 133.

## Revendications

1. Dispositif, appelé compteur centralisateur (120), destiné à être inclus dans un système de gestion automatisée de comptage dans le cadre d'un service de distribution électrique, le compteur centralisateur (120) comportant une première unité de communication (304) par courants porteurs en ligne configurée pour effectuer des communications par courants porteurs en ligne dans une première bande fréquentielle, la première unité de communication (304) par courants porteurs en ligne étant destinée à communiquer avec un concentrateur de données (110) via un premier réseau de communication par courants porteurs en ligne (100), le compteur centralisateur (120) comportant en outre :
- une seconde unité de communication (305) par courants porteurs en ligne configurée pour effectuer des communications par courants porteurs en ligne dans une seconde bande fréquentielle distincte de la première bande fréquentielle, la seconde unité de communication (305) par courants porteurs en ligne étant destinée à communiquer avec une pluralité de dispositifs, appelés compteurs basiques déportés (131, 132, 133), via un second réseau de communication par courants porteurs en ligne (101),
- une unité de contrôle (302) configurée pour émuler une application de compteur électrique intelligent (311, 312, 313) vis-à-vis du concentrateur de données (110) pour chaque compteur basique déporté (131, 132, 133) enregistré auprès du compteur centralisateur (120) via le second réseau de communication par courants porteurs en ligne (101), de sorte que chaque compteur basique déporté (131, 132, 133) est perçu par le concentrateur de données (110) comme étant localisé dans le compteur centralisateur (120) au sein du premier réseau de communication par courants porteurs en ligne (100),
dans lequel l'unité de contrôle (302) est configurée pour répondre à des sollicitations applicatives du concentrateur de données (110) vis-à-vis des compteurs basiques déportés (131, 132, 133) dans le cadre du service de distribution électrique, en commandant les compteurs basiques déportés (131, 132, 133) grâce à un jeu de commandes atomiques de métrologie et de gestion de coupe-circuit,
et le compteur centralisateur (120) comporte en outre une unité d'interface utilisateur (303) comportant un afficheur et un panneau de contrôle adapté pour permettre à un utilisateur de saisir un mot de passe, et dans lequel l'unité de contrôle (302) est configurée pour vérifier qu'un mot de passe saisi pour un compteur basique déporté (131, 132, 133) correspond à un mot de passe attendu pour ledit compteur basique déporté (131, 132, 133), et si tel est le cas, l'unité de contrôle (302) est configurée pour récupérer un relevé d'index de comptage auprès de l'instance de l'application émulée (311, 312, 313) correspondant audit compteur basique déporté (131, 132, 133) et pour instruire l'unité d'interface utilisateur (303) d'afficher sur l'afficheur le relevé d'index de comptage récupéré.

2. Dispositif selon la revendication 1, dans lequel la première unité de communication (304) est munie d'un premier filtre (306) adapté pour supprimer la seconde bande fréquentielle.

3. Dispositif selon la revendication 1 ou 2, dans lequel la seconde unité de communication (305) est munie d'un second filtre (307) adapté pour supprimer la première bande fréquentielle.

4. Dispositif selon l'une quelconque des revendications 1 à 3, dans lequel la première bande fréquentielle est de type CENELEC-A et la seconde bande fréquentielle est de type FCC.

5. Dispositif selon l'une quelconque des revendications 1 à 4, dans lequel le compteur centralisateur (120) effectue une opération d'enregistrement en coopération avec chaque compteur basique déporté (131, 132, 133) en implémentant :
- des moyens pour recevoir une requête d'adhésion ;
- des moyens pour transmettre en réponse une première requête d'identification qui inclut un premier nombre aléatoire, ainsi qu'un identifiant qui identifie le compteur centralisateur (120) ;
- des moyens pour recevoir en retour une première réponse d'identification qui inclut un second nombre aléatoire, ainsi qu'un identifiant dudit compteur basique déporté (131, 132, 133) en question et un premier résultat de calcul résultant d'une exécution de fonction prédéfinie prenant en entrée le premier nombre aléatoire, le second nombre aléatoire et une clef secrète connue du compteur basique déporté (131, 132, 133) en question et du compteur centralisateur (120) ;
- des moyens pour transmettre au compteur basique déporté (131, 132, 133) en question, après vérification du premier résultat de calcul, une seconde requête d'identification, qui inclut un second résultat de calcul résultant d'une exécution de fonction prédéfinie prenant en entrée le second nombre aléatoire et ladite clef secrète, la seconde requête d'identification contenant en outre, sous forme chiffrée, une clef de chiffrement qui est utilisée par la suite pour chiffrer les échanges entre le compteur basique déporté (131, 132, 133) en question et le compteur centralisateur (120).

6. Dispositif selon l'une quelconque des revendications 1 à 5, dans lequel le jeu de commandes atomiques de métrologie et de gestion de coupe-circuit inclut une commande de mise à l'heure.

7. Système de comptage destiné à être utilisé dans un système de gestion automatisée de comptage destiné à être utilisé dans le cadre d'un service de distribution électrique, le système de comptage comportant :
- un dispositif, appelé compteur centralisateur (120), selon l'une quelconque des revendications 1 à 6, et
- la pluralité de compteurs basiques déportés (131, 132, 133), connectés au compteur centralisateur (120) via le second réseau de communication par courants porteurs en ligne (101).

8. Système de comptage destiné à être utilisé dans un système de gestion automatisée de comptage destiné à être utilisé dans le cadre d'un service de distribution électrique, le système de comptage comportant :
- un dispositif, appelé compteur centralisateur (120), selon la revendication 6, et
- la pluralité de compteurs basiques déportés (131, 132, 133), connectés au compteur centralisateur (120) via le second réseau de communication par courants porteurs en ligne (101),
et la commande de mise à l'heure est utilisée pour horodater des relevés d'index de comptage effectués par l'unité de métrologie (353) de chaque compteur basique déporté (131, 132, 133).

9. Système de gestion automatisée de comptage destiné à être utilisé dans le cadre d'un service de distribution électrique comportant :
- le système de comptage selon la revendication 7,
- le premier réseau de communication par courants porteurs en ligne (100),
- le concentrateur de données (110), et
- des compteurs électriques intelligents (121, 122, 123) connectés au concentrateur de données via le premier réseau de communication par courants porteurs en ligne (100).

10. Système de gestion automatisée de comptage selon la revendication 8, dans lequel le second réseau de communication par courants porteurs en ligne (101) a une topologie en étoile et le premier réseau de communication par courants porteurs en ligne (100) a une topologie maillée ou en arbre de recouvrement.

11. Procédé implémenté par un dispositif, appelé compteur centralisateur (120), inclus dans un système de gestion automatisée de comptage dans le cadre d'un service de distribution électrique, le procédé comportant les étapes suivantes :
- effectuer (504) des communications par courants porteurs en ligne dans une première bande fréquentielle avec un concentrateur de données (110) via un premier réseau de communication par courants porteurs en ligne (100),
- effectuer (456) des communications par courants porteurs en ligne dans une seconde bande fréquentielle distincte de la première bande fréquentielle avec une pluralité de dispositifs, appelés compteurs basiques déportés (131, 132, 133), via un second réseau de communication par courants porteurs en ligne (101),
- émuler (453) une application de compteur électrique intelligent vis-à-vis du concentrateur de données (110) pour chaque compteur basique déporté (131, 132, 133) enregistré auprès du compteur centralisateur (120) via le second réseau de communication par courants porteurs en ligne (101), de sorte que chaque compteur basique déporté (131, 132, 133) est perçu par le concentrateur de données (110) comme étant localisé dans le compteur centralisateur (120) au sein du premier réseau de communication par courants porteurs en ligne (100), et
- répondre (504) à des sollicitations applicatives du concentrateur de données (110) vis-à-vis des compteurs basiques déportés (131, 132, 133) dans le cadre du service de distribution électrique, en commandant les compteurs basiques déportés (131, 132, 133) grâce à un jeu de commandes atomiques de métrologie et de gestion de coupe-circuit,
et, le compteur centralisateur (120) comportant en outre une unité d'interface utilisateur (303) comportant un afficheur et un panneau de contrôle adapté pour permettre à un utilisateur de saisir un mot de passe, le procédé comporte en outre les étapes suivantes :
- vérifier qu'un mot de passe saisi pour un compteur basique déporté (131, 132, 133) correspond à un mot de passe attendu pour ledit compteur basique déporté (131, 132, 133), et si tel est le cas, récupérer un relevé d'index de comptage auprès de l'instance de l'application émulée (311, 312, 313) correspondant audit compteur basique déporté (131, 132, 133) et instruire l'unité d'interface utilisateur (303) d'afficher sur l'afficheur le relevé d'index de comptage récupéré.

12. Produit programme d'ordinateur, **caractérisé en ce qu'**il comporte des instructions entraînant l'exécution par un dispositif, appelé compteur centralisateur (120), du procédé selon la revendication 11, lorsque lesdites instructions sont exécutées par un processeur (201) dudit compteur centralisateur (120).

13. Support de stockage, **caractérisé en ce qu'**il stocke un programme d'ordinateur comportant des instructions entraînant l'exécution par un dispositif, appelé compteur centralisateur (120), du procédé selon la revendication 11, lorsque lesdites instructions sont lues et exécutées par un processeur (201) dudit compteur centralisateur (120).
